(19) **Europäisches Patentamt / European Patent Office / Office européen des brevets**

(11) **EP 4 742 844 A1**

(12) **EUROPEAN PATENT APPLICATION**
published in accordance with Art. 153(4) EPC

(43) Date of publication:
**13.05.2026 Bulletin 2026/20**

(21) Application number: **24839406.6**

(22) Date of filing: **13.06.2024**

(51) International Patent Classification (IPC):
*H05K 7/20* (2006.01)    *B32B 15/08* (2006.01)
*H01L 23/36* (2006.01)    *H05K 9/00* (2006.01)

(52) Cooperative Patent Classification (CPC):
**B32B 15/08; H05K 7/20; H05K 9/00; H10W 40/10**

(86) International application number:
**PCT/JP2024/021565**

(87) International publication number:
**WO 2025/013510 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.07.2023 JP 2023112573**

(71) Applicant: **JX Advanced Metals Corporation Tokyo 105-8417 (JP)**

(72) Inventor: **ORI, Yuki Hitachi-shi, Ibaraki 317-0056 (JP)**

(74) Representative: **Mewburn Ellis LLP Aurora Building Counterslip Bristol BS1 6BX (GB)**

(54) **LAMINATE, HEAT DISSIPATION MEMBER, METHOD FOR MANUFACTURING SAME, HEAT DISSIPATION HOUSING, AND METHOD FOR MANUFACTURING SAME**

(57)    Provided is a laminate having good heat dissipation properties while reducing weight. A laminate having at least one metal layer and at least one resin layer, wherein a unit weight of the laminate is 2.0 kg/m² or less, and a thermal diffusivity of the laminate in a direction perpendicular to a lamination direction is $10 \times 10^{-6}$ m²/s or more.

## Description

[Technical Field]

This invention relates to a laminate, a heat dissipation member, and method for manufacturing the same, and a heat dissipation housing and a method for manufacturing the same.

[Background Art]

In recent years, interest in global environmental issues has been growing worldwide, and environmentally friendly vehicles equipped with rechargeable batteries, such as electric vehicles and hybrid vehicles, are becoming increasingly popular. Many of these vehicles use a system in which DC current generated from a mounted rechargeable battery is converted to AC current via an inverter, and necessary power is then supplied to an AC motor to obtain driving power. Electronic control units (ECUs) are also used in such automobiles to electronically control the engine drive, driving support systems, and the like.

However, electronic devices such as inverters and ECUs are becoming smaller and more highly integrated, causing a problem of an increase in a temperature due to increased heat generation. The increase in the temperature of the electronic device can cause operational failures. Therefore, various measures must be taken to control the increase in the temperature of the electronic device.

One means for achieving this would be to use SUS with excellent heat dissipation properties as a housing, as described in Patent Literature 1, for example.

[Citation List]

[Patent Literature]

[PTL 1] Japanese Patent Application Publication No. 2020-172694 A

[Summary of Invention]

[Technical Problem]

By the way, from the viewpoint of extending the cruising range of electric vehicles and the like, attention is being paid to improving the electric power cost (cruising range per unit of electric power). However, since the SUS housing described above is relatively heavy, housing the electronic device within the housing will likely reduce the cost of electricity for electric vehicles and the like.

Furthermore, the replacement of SUS housings with resin housings is currently being considered from the viewpoint of weight reduction for electric vehicles and the like. However, the resin housings have lower heat dissipation properties than the SUS housings. Therefore, as the temperature of the electronic device increases, it may cause the electric device to malfunction.

Thus, in an embodiment of this invention, an object is to provide a laminate having good heat dissipation properties while reducing weight.

[Solution to Problem]

As a result of intensive studies, the inventors have found that, in order to improve the heat dissipation properties of a three-dimensional molded article such as a housing while reducing the weight, it is important to form a laminate having at least one metal layer and at least one resin layer, while controlling the thermal diffusivity of the laminate in a direction perpendicular to a lamination direction to an appropriate range. This invention has been completed on the basis of these findings, and is illustrated below.

[1] A laminate having at least one metal layer and at least one resin layer,
wherein a unit weight of the laminate is 2.0 kg/m$^2$ or less, and a thermal diffusivity of the laminate in the direction perpendicular to a lamination direction is $10 \times 10^{-6}$ m$^2$/s or more.
[2] The laminate according to [1], wherein the thermal diffusivity of the resin layer in a direction perpendicular to the lamination direction is $0.05 \times 10^{-6}$ to $0.70 \times 10^{-6}$ m$^2$/s.
[3] The laminate according to [1] or [2], wherein the resin layer comprises a magnetic metal material.
[4] The laminate according to any one of [1] to [3], wherein the metal layer comprises at least one selected from copper, copper alloy, aluminum, and aluminum alloy.

[5] A heat dissipation member having the laminate according to any one of [1] to [4].

[6] A method for manufacturing a heat dissipation member, the method comprising a step of manufacturing a heat dissipation member using the laminate according to any one of [1] to [4].

[7] A heat dissipation housing having the laminate according to any one of [1] to [4].

[8] A method for manufacturing a heat dissipation housing, the method comprising a step of manufacturing a heat dissipation housing using the laminate according to any one of [1] to [4].

[Advantageous Effects of Invention]

In an embodiment of this invention, it is possible to have good heat dissipation properties while reducing the weight.

[Brief Description of Drawings]

[FIG. 1]

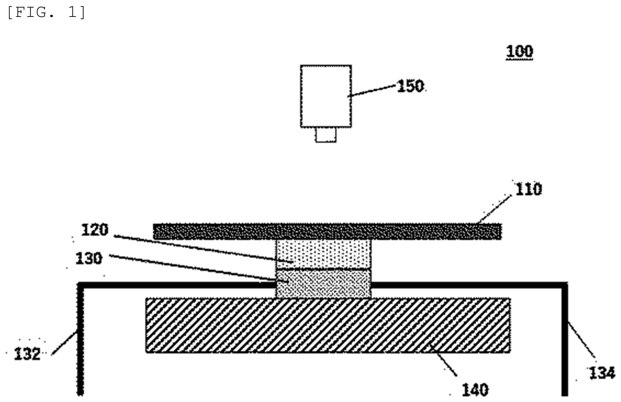

FIG. 1 is a schematic view of a heat dissipation evaluation device used to evaluate heat dissipation properties of sheet-shaped samples according to Examples 1 to 5, Comparative Example 1, and Reference Example 1.

[FIG. 2]

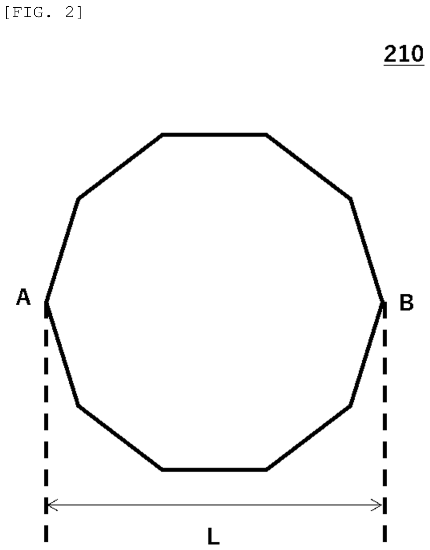

FIG. 2 is schematic views of sheet-shaped samples according to Examples 1 to 5, Comparative Example 1, and Reference Example 1 before three-dimensional molding.

[FIG. 3]

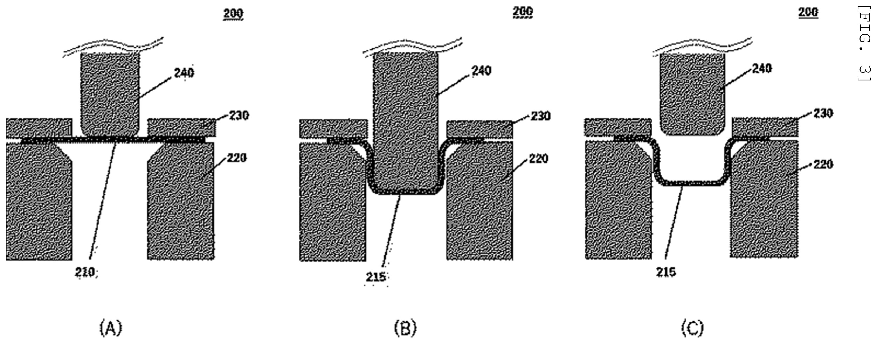

FIG. 3 is a schematic view for explaining a method for producing three-dimensional molded samples from sheet-shaped samples according to Examples 1 to 5 and Reference Example 1.

[FIG. 4]

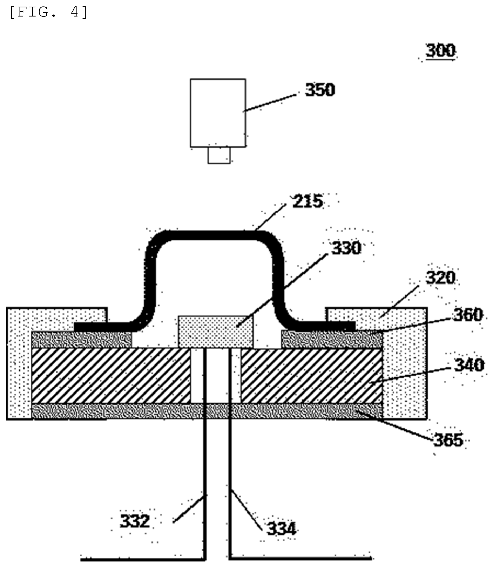

FIG. 4 is a schematic view of a heat dissipation evaluation device used to evaluate heat dissipation properties of three-dimensional molded samples according to Examples 1 to 5, Comparative Example 1, and Reference Example 1.

[Description of Embodiments]

Hereinafter, this invention is not limited to each embodiment, and components can be modified and embodied without departing from the spirit of the invention. Further, various inventions can be formed by appropriately combining a plurality of components disclosed in each embodiment.

[1. Laminate]

In an embodiment, the laminate according to this invention has at least one metal layer and at least one resin layer. In the laminate, at least one metal layer and at least one resin layer are alternately laminated, so that the weight of the laminate can be reduced as compared to a single metal layer having the same thickness as that of the laminate. The laminate can be used as a heat dissipation member.

(Unit Weight)

In an embodiment, from the viewpoint of weight reduction, the unit weight of the laminate is 2.0 kg/m$^2$ or less. The laminate contains the resin layer with a relatively low unit weight, which allows for weight reduction. The upper limit of the unit weight is preferably 1.5 kg/m$^2$ or less, and more preferably 1.0 kg/m$^2$ or less. The lower limit of the unit weight is typically 0.1 kg/m$^2$ or more, and more typically 0.2 kg/m$^2$ or more.

Next, the unit weight can be measured by measuring the weight of the sheet-shaped sample cut into a 10 cm square and dividing the weight by the area.

(Thermal Diffusivity)

In an embodiment, from the viewpoint of ensuring good heat dissipation properties when made into a three-dimensional molded article, the thermal diffusivity of the laminate in a direction perpendicular to a lamination direction is 10 $\times$ 10$^{-6}$ m$^2$/s or more. The lower limit of the thermal diffusivity is preferably 15 $\times$ 10$^{-6}$ m$^2$/s or more, and more preferably 20 $\times$ 10$^{-6}$ m$^2$/s or more. Further, in view of the fact that heat dissipation properties tend to saturate when the thermal diffusivity exceeds a certain value, the upper limit is typically $140 \times 10^{-6}$ m$^2$/s or less.

In this invention, the thermal diffusivity is an index obtained by dividing a thermal conductivity by a specific heat and density, and indicates a speed at which a temperature gradient within a substance is alleviated. In other words, even if the thermal conductivity is higher, applying a certain amount of heat leads to a small temperature change when the specific heat or density of the material is larger, and particularly when different materials are combined as in the laminate in this case, the heat dissipation properties cannot be evaluated by thermal conductivity. However, by evaluating the thermal diffusivity of the entire laminate in the direction perpendicular to the lamination direction, the heat dissipation properties that disperse hot spots can be evaluated. The inventors have found that, although there is no correlation between the thermal diffusivity of the laminate in the direction perpendicular to the lamination direction and the heat dissipation properties in the sheet-shaped article, there tends to be a correlation when it is made into a three-dimensional molded article. As its reason, the inventors speculate that the temperature change in the sheet-shaped sample is dominated by thermal conduction within the sheet, whereas in the three-dimensional molded article, the influence of heat transfer between the heat source and the air near the heat source is added in addition to thermal conduction, resulting in a greater influence of thermal diffusivity.

Next, the method for measuring the thermal diffusivity is as follows: The laminate is used as a sample, and the temperature is measured using a thermal property measuring device, Thermowave Analyzer TA35 Ultimate (manufactured by Bethel Corporation) or an equivalent device. A surface of the sample for which the thermal diffusivity $\kappa$ is to be measured is then spot-heated at room temperature (ordinary temperature) + about 10°C by a periodic heating source $P_0 e^{1\omega t}$.

The AC component of the temperature at the heating point is expressed as $T_{ac} = T_0 e^{i\omega t}$. The temperature propagation induced in the surroundings by the periodic heat source $P_0 e^{i\omega t}$ can be expressed by the following equation I. Each symbol in the following equations I to V has the following means:

$\kappa$: thermal diffusivity [m$^2$/s];
f: heating frequency [Hz];
a: distance from heat source - slope of phase graph [rad./m];
$\theta$: phase [rad.];
r: distance from heat source [m];
$\mu$: thermal diffusion length [m];
$\omega$: angular frequency [rad./s];
T: temperature [K];
i: imaginary number;
t: time [s];
k: wavenumber of temperature wave [1/m];
$\pi$: pi;
P: laser power;
$\rho$: density; and
c: specific heat.

[Equation I]

$$T_{ac} = \frac{P_0}{4\pi \kappa r \rho c} \cdot e^{-kr + i(\omega t - kr)} \quad \cdots \text{ Equation I}$$

The wave number k of the temperature wave in the above equation I is expressed by the following equation II:
[Equation II]

$$k = \sqrt{\frac{\omega}{2\kappa}} = \sqrt{\frac{\pi f}{\kappa}} = \frac{1}{\mu} \quad \cdots \text{ Equation II}$$

Therefore, the phase $\theta$ in the above equation I is expressed by the following equation III.

[Equation III]

$$\theta = \sqrt{\dfrac{\pi f}{\kappa}} \cdot r \quad \cdots \cdot \text{ Equation III}$$

Based on the above equation III, the results of measuring the direction perpendicular to the thickness direction (lamination direction) of the sample are analyzed. Subsequently, r in the above equation III is determined as a distance 1 from the heating point, and the distance 1 is plotted on the horizontal axis and the phase θ on the vertical axis. Here, the slope a of the obtained graph is the following equation IV:

[Equation IV]

$$a = - \sqrt{\dfrac{\pi f}{\kappa}} \quad \cdots \cdot \text{ Equation IV}$$

Therefore, the thermal diffusivity κ is the following equation V:

[Equation V]

$$\kappa = \dfrac{\pi f}{a^2} \quad \cdots \cdot \text{ Equation V}$$

(Laminate Structure)

Examples of the lamination structure of the laminate include the following:

(1) When the laminate has two-layer structure as the lamination structure, it includes, for example, a metal layer/resin layer.
(2) When the laminate has a three-layer structure as the lamination structure, examples of the structure include metal layer/resin layer/metal layer, resin layer/metal layer/resin layer, resin layer/metal layer/metal layer, and metal layer/resin layer/resin layer.
(3) When the laminate has a four-layer structure as the lamination structure, examples of the structure include metal layer/metal layer/metal layer/resin layer, metal layer/metal layer/resin layer/metal layer, metal layer/metal layer/resin layer/resin layer, metal layer/resin layer/metal layer/resin layer, metal layer/resin layer/metal layer/resin layer, and metal layer/resin layer/resin layer/metal layer.
(4) When the laminate has a five-layer structure as the lamination structure, examples of the structure includes metal layer/resin layer/metal layer/resin layer/metal layer, resin layer/metal layer/resin layer/metal layer/resin layer, metal layer/metal layer/metal layer/metal layer/resin layer, metal layer/metal layer/metal layer/resin layer/metal layer, metal layer/metal layer/metal layer/resin layer/resin layer, metal layer/metal layer/resin layer/metal layer/metal layer, metal layer/metal layer/resin layer/metal layer/resin layer, metal layer/metal layer/resin layer/resin layer/metal layer, metal layer/resin layer/metal layer/metal layer/resin layer, metal layer/resin layer/metal layer/resin layer/metal layer, metal layer/resin layer/metal layer/resin layer/resin layer, metal layer/resin layer/resin layer/metal layer/resin layer, metal layer/resin layer/resin layer/resin layer/metal layer, metal layer/resin layer/resin layer/resin layer/resin layer, resin layer/metal layer/metal layer/metal layer/resin layer, resin layer/metal layer/metal layer/resin layer/resin layer, resin layer/resin layer/metal layer/resin layer/resin layer, and resin layer/resin layer/resin layer/metal layer/resin layer.

(5)When the laminate has a six-layer structure as a lamination structure, examples of the structure include metal layer/resin layer/metal layer/resin layer/metal layer/resin layer, metal layer/metal layer/metal layer/metal layer/metal layer/resin layer, metal layer/metal layer/metal layer/metal layer/resin layer/metal layer, metal layer/metal layer/metal layer/metal layer/resin layer/resin layer, metal layer/metal layer/metal layer/resin layer/metal layer/metal layer, metal layer/metal layer/metal layer/resin layer/metal layer/resin layer, metal layer/metal layer/metal layer/resin layer/resin layer/metal layer, metal layer/metal layer/metal layer/resin layer/resin layer/resin layer, metal layer/metal layer/resin layer/metal layer/metal layer/resin layer, metal layer/metal layer/resin layer/metal layer/resin layer/metal layer, metal layer/metal layer/resin layer/metal layer/resin layer/resin layer, metal layer/metal layer/resin layer/resin layer/metal layer/metal layer, metal layer/metal layer/resin layer/resin layer/metal layer/resin layer, metal layer/metal layer/resin layer/resin layer/resin layer/metal layer, metal layer/metal layer/resin layer/resin layer/resin layer/resin layer, metal layer/resin layer/metal layer/metal layer/metal layer/resin layer, metal layer/resin layer/metal layer/metal layer/resin layer/metal layer, metal layer/resin layer/metal layer/resin layer/resin layer/metal layer, metal layer/resin layer/resin layer/resin layer/resin layer/metal layer, resin layer/metal layer/metal layer/metal layer/metal layer/resin layer, resin layer/metal layer/metal layer/metal layer/resin layer/resin layer, resin layer/metal layer/metal layer/resin layer/metal layer/resin layer, resin layer/metal layer/metal layer/resin layer/resin layer/metal layer, resin layer/metal layer/metal layer/resin layer/resin layer/resin layer, resin layer/metal layer/resin layer/metal layer/resin layer/resin layer, resin layer/metal layer/resin layer/resin layer/resin layer/resin layer, resin layer/metal layer/resin layer/resin layer/resin layer/metal layer/resin layer, and resin layer/resin layer/metal layer/resin layer/resin layer/resin layer.

(6) When the laminate has a seven-layer structure as a lamination structure, examples of the structure include resin layer/metal layer/resin layer/resin layer/resin layer/metal layer/resin layer, resin layer/metal layer/resin layer/metal layer/resin layer/metal layer/resin layer, metal layer/resin layer/metal layer/resin layer/metal layer/resin layer/metal layer, and the like.

(Entire Thickness)

From the viewpoint of moldability, the thickness of the laminate is preferably 70 μm or more, more preferably 100 μm or more, and even more preferably 200 μm or more. However, from the viewpoint of weight reduction and drilling processability, the thickness of the laminate is preferably 2000 μm or less, more preferably 1000 μm or less, and even more preferably 700 μm or less.

The thickness of the laminate can be measured using a constant pressure thickness tester (THICKNESS METER B-1, manufactured by Toyo Seiki Seisakusho Co., Ltd.) in accordance with Method A of JIS K 6250: 2019, and can be obtained by averaging the measured values at four points on the sheet-shaped sample surface. The measurement can be performed with an indenter having a diameter of 5 mm and at a pressure of 0.196 N applied to the indenter.

A ratio (M/R) of the total thickness (M) of the metal layers to the total thickness (R) of the resin layers can be appropriately set, but from the viewpoint of moldability, it is, for example, 0.05 to 0.40.

(Lamination Method)

The resin layer and the metal layer may be laminated by using an adhesive between the resin layer and the metal layer, or by thermal compression bonding of the resin layer to the metal layer without using an adhesive. Although a method of simply stacking the sheets without using the adhesive may be used, taking into consideration the integrity of the laminate, it is preferable to join at least the ends (e.g., each side if the laminate is rectangular) with a tape or adhesive, or by thermal compression bonding.

The adhesive includes, but not limited to, acrylic resin-based, epoxy resin-based, urethane-based, polyester-based, silicone resin-based, vinyl acetate-based, styrene butadiene rubber-based, nitrile rubber-based, phenolic resin-based, and cyanoacrylate-based adhesives, and from the viewpoints of ease of production and cost, urethane-based, polyester-based, and vinyl acetate-based adhesives are preferred.

<Metal Layer>

The material of the metal layer is not particularly limited, but it is preferable that the metal layer contains at least one material selected from the group consisting of copper, copper alloy, aluminum, and aluminum alloy. From the viewpoint of electromagnetic wave shielding, a material having a conductivity of $1.0 \times 10^6$ S/m or more is preferable. These are preferred for practical purposes.

(Thickness)

The lower limit of the thickness per layer is, for example, 4 μm or more, and for example, 10 μm or more. On the other hand, the upper limit of the thickness per layer is, for example, 70 μm or less, and, for example, 50 μm or less.

The thickness of the metal layer can be measured by the same method as that of the thickness of the laminate. If the thickness of the metal layer in the laminate is to be measured, it can be measured by observing the thickness cross section with an SEM or the like.

In an embodiment, when a plurality of metal layers are formed, all the metal layers may be made of the same material, or different materials may be used for each layer. Furthermore, all the metal layers may have the same thickness, or the thicknesses of the layers may vary.

In an embodiment, the total thickness of the metal layers is, for example, 4 to 420 μm.

The lower limit of the total thickness is, for example, 10 μm or more, and for example, 30 μm or more. On the other hand, the upper limit of the total thickness is, for example, 110 μm or less, and for example, 70 μm or less.

The shape of the metal layer is not particularly limited, but it may be, for example, a metal foil. When a copper foil is used as the metal foil, it is preferable that the copper has a high purity, since this improves the shielding properties. The purity is preferably 99.5% by mass or more, and more preferably 99.8% by mass or more. As the copper foil, rolled copper foil, electrolytic copper foil, metallized copper foil, and the like can be used, but rolled copper foil, which has excellent formability, is preferred. When alloy elements are added to the copper foil to produce a copper alloy foil, the total content of these elements and unavoidable impurities may be less than 0.5% by mass. In particular, it is preferable that the copper foil contains 50 to 2000 ppm by mass of at least one selected from tin, manganese, chromium, zinc, zirconium, magnesium, nickel, silicon, and silver in total, and/or 10 to 50 ppm by mass of phosphorus, because this improves the elongation as compared to a pure copper foil having the same thickness.

(Processed Film)

From the viewpoint of improving heat dissipation properties, the processed film is formed on at least one surface of the metal layer, and may further include, for example, one or more selected from an auxiliary electromagnetic wave absorbing film of an alloy containing copper, a heat resistant film, a rust proofing film, and a weather resistant film. Examples of the heat resistant films that has undergone heat resistant processing include plated films and vapor deposition films containing cobalt or nickel, examples of the rust proofing film that has undergone rust proofing processing include inorganic plated films such as zinc or chromium, vapor deposition films, and organic films such as benzotriazole, and examples of weather resistant films that has undergone silane coupling processing include organic coating films containing a silane coupling agent. That is, the processed film may further contain, in addition to copper, cobalt and nickel, one or more elements selected from zinc, molybdenum, tin, phosphorus, tungsten, chromium and silicon. The processed film interposed between the metal layer and the resin layer can also enhance the adhesion between the metal layer and the resin layer. The processed film can also improve shielding properties.

The auxiliary electromagnetic wave absorbing film can be prepared by a known method, for example, a plating process, a metal vapor deposition process, a sputtering process, or the like. Among these, the method of forming the auxiliary electromagnetic wave absorbing film made of copper, cobalt and nickel by subjecting the surface of the metal layer to plating will be described below as an example.

In the plating process for forming the auxiliary electromagnetic wave absorbing film, a particle film made of copper, cobalt and nickel is formed on at least one surface of the metal layer.

(Plating Conditions (Roughening Plating): Copper, Cobalt and Nickel Alloy Plating)

An example of the plating conditions for copper, cobalt and nickel is as follows:

Liquid composition: 10 to 20g/L of copper, 5 to 15g/L of cobalt, 5 to 15g/L of nickel;
pH: 2 to 3;
Liquid temperature: 30 to 50°C;
Current density: 10 to 60A/dm$^2$; and
Coulomb amount: 10 to 48 As/dm$^2$.

In this case, the roughening plating process can be carried out in multiple stages under the above plating conditions.

In the heat resistant process, at least one of the following heat resistant films 1 and 2 can be further formed on the auxiliary electromagnetic wave absorbing film as described above. Each plating and deposition condition is shown below.

(Plating Conditions for Heat Resistant Film 1) (Co-Ni Plating: Cobalt-Nickel Alloy Plating)

Liquid composition: 5 to 20g/L of nickel, 1 to 8g/L of cobalt;
pH: 2 to 3;
Liquid temperature: 40 to 60°C;
Current density: 10 to 30A/dm$^2$; and
Coulomb amount: 2 to 20 As/dm$^2$.

(Plating Conditions for Heat Resistant Film 2) (Ni-Zn Plating: Nickel-Zinc Alloy Plating)

Liquid composition: 2 to 30g/L of nickel, 2 to 30g/L of zinc;
pH: 3 to 4;
Liquid temperature: 30 to 50°C;
Current density: 1 to 10A/dm$^2$; and
Coulomb amount: 0.5 to 2 As/dm$^2$.

In the rust roofing process, the following rust proofing film and/or weather resistant film can be further formed on the auxiliary electromagnetic wave absorbing film or heat resistant film as described above. Each condition is shown below.

(Rust Proofing Plating Conditions)

Liquid composition: 1 to 10g/L of potassium dichromate, 0.2 to 0.5g/L of zinc;
pH: 3 to 4;
Liquid temperature: 50 to 70°C;
Current density: 0 to 2 A/dm$^2$ (0 A/dm$^2$ is for an immersion chromate process); and
Coulomb amount: 0 to 2 As/dm$^2$ (0 As/dm$^2$ is for an immersion chromate treatment).

(Type of Weather Resistant Film (Silane Coupling Film))

An example includes applying an aqueous diaminosilane solution or an aqueous epoxysilane solution.
In addition, when a metal film such as a heat resistant film or a plated film is formed by vapor deposition (dry plating) such as sputtering, and when a metal film such as a heat resistant film or a plated film is formed by plating (wet plating) and the metal film such as a heat resistant film or the plated film is formed by normal plating (smooth plating, i.e., plating performed at a current density less than the limiting current density), the metal film or plated film does not affect the surface shape of the copper foil.
The limiting current density varies depending on the metal concentration, pH, solution feeding speed, electrode distance, and plating solution temperature. In this invention, the current density at a boundary between normal plating (a state where the plated metal is deposited in a form of a film) and roughened plating (burnt plating; a state where the plated metal is deposited in a a form of crystal (spherical, needle-shaped, frost-shaped; there are irregularities) is defined as the limiting current density, and the current density at the limit of normal plating (just before burnt plating) in the Hull cell test (visually determined) is determined as the limiting current density.
Specifically, the metal concentration, pH, and plating solution temperature are set to the plating production conditions, and the Halsell test is conducted. Then, the state where the metal layer is formed (whether the plated metal is deposited in a form of a layer or formed in a form of crystal) is investigated for the plating solution composition and plating solution temperature. Then, the current density at a position of a test piece in which there is the boundary between normal plating and roughened plating on the test piece is determined, based on the current density quick reference table from YAMAMOTO-MS CO., LTD. The current density at the position of the boundary is defined as the limiting current density. The limiting current density for the plating solution composition and plating solution temperature can be thus determined. In general, when the electrode distance is shorter, the limiting current density tends to be higher.
The method of the Hull Cell test is described, for example, in "Plating Practice Reader" by Kiyoshi Maruyama, published by The Nikkan Kogyo Shimbun on June 30, 1983, pages 157 to 160.

In order to perform the plating process at less than the limiting current density, the current density during the plating process is preferably 20 A/dm$^2$ or less, more preferably 10 A/dm$^2$ or less, and even more preferably 8 A/dm$^2$ or less.
Furthermore, the rust proofing film and weather resistant film are extremely thin and do not affect the surface shape of the copper foil.

\<Resin Layer\>

From the viewpoint of controlling the thermal diffusivity in the direction perpendicular to the lamination direction in the laminate, it is preferable to use a resin having a thermal diffusivity in the direction perpendicular to the lamination direction of, for example, $0.05 \times 10^{-6}$ m$^2$/s to $0.70 \times 10^{-6}$ m$^2$/s for the resin layer. The upper limit of the thermal diffusivity is, for example, $0.68 \times 10^{-6}$ m$^2$/s or less. The lower limit of the thermal diffusivity is, for example, $0.05 \times 10^{-6}$ m$^2$/s or more, and for example, $0.07 \times 10^{-6}$ m$^2$/s or more.
The thermal diffusivity can be measured by the method described above.
The resin layer may further contain a magnetic metal material. Examples include composite sheets obtained by mixing and dispersing a magnetic metal material and a resin and integrally molding them. Examples of the resin contained in the composite sheet include natural resins and synthetic resins, the synthetic resins being preferred from the viewpoint of processability. These materials may also contain fiber reinforcing materials such as carbon fiber, glass fiber, and aramid fiber.
For the synthetic resin, any resin having the thermal diffusivity as described above can be used as needed.
The composite sheet can be laminated in the form of a film or fiber onto the resin layer or the metal layer. Although the composite sheet can be obtained by applying an uncured, mixed composition of the magnetic metal material and the resin to a resin substrate having a release layer, curing the composition, and then peeling it off from the resin substrate, for example, the composite sheet may be formed by applying an uncured mixed composition of the magnetic metal material and the resin to the surface of the resin layer or the surface of the metal layer or the processed film described above, and then curing the composition. Further, for reasons of ease of production, it is preferable to form a composite sheet that can be attached to the surface of the resin layer, or the surface of the metal layer, or the processed film as described below.
The volume ratio of the resin to the magnetic metal material in the composite sheet is, for example, 75:25 to 1:99. A method for calculating the volume ratio of the resin to the magnetic metal material can involve, for example, calculating an area ratio of the magnetic metal material on the surface perpendicular to the thickness direction of the composite sheet by SEM observation, calculating a thickness ratio of the magnetic metal material to the thickness of the composite sheet in the thickness direction by SEM observation, calculating a volume ratio of the magnetic metal material in the composite sheet from the product of those so that the volume ratio is resin:magnetic metal material = (100 - volume ratio of magnetic metal material):volume ratio of magnetic metal material.
Further, the composite sheet may further contain conductive particles and conductive fibers other than the magnetic metal material as long as they do not impair this invention. As the metal species of the conductive particles or conductive fibers, any known material having good conductivity can be used, and examples thereof include copper, copper alloy, aluminum, aluminum alloy, and carbon. In this case, the mass ratio of the resin to the conductive particles or conductive fibers is, for example, 70:30 to 1:99.
The magnetic metal material preferably contains at least one selected from nickel, iron, permalloy (Ni-Fe alloy), silicon iron, permendur, sendust (Fe-Si-Al alloy), soft ferrite, Fe-based amorphous, Co-based amorphous, and nanocrystals. It is presumed that a higher filling rate of these materials when they are combined provides better heat dissipation properties of the laminate laminated with a metal layer.

(Thickness)

The lower limit of the thickness per layer is, for example, 5 $\mu$m or more, and for example, 10 $\mu$m or more. On the other hand, the upper limit of the thickness per layer is, for example, 300 $\mu$m or less, and, for example, 200 $\mu$m or less.
The thickness of the resin layer can be measured by the same method as that of the thickness of the laminate. If the thickness of the resin layer in the laminate is to be measured, it can be measured by observing the thickness cross section with an SEM or the like.
In an embodiment, when a plurality of resin layers are formed, all the resin layers may be made of the same material, or different materials may be used for each layer. Furthermore, all the resin layers may have the same thickness, or the thicknesses of the layers may vary.
In an embodiment, the total thickness of the resin layers is, for example, 10 to 1200 $\mu$m.
The lower limit of the total thickness is, for example, 10 $\mu$m or more, and for example, 20 $\mu$m or more. On the other hand, the upper limit of the total thickness is, for example, 1200 $\mu$m or less, and for example, 1000 $\mu$m or less.

[2. Heat Dissipation Member]

In an embodiment, the heat dissipation member according to this invention has the laminate described above. The heat dissipation member according to this invention can also be used for electromagnetic shielding applications.

In an embodiment, the method for producing the heat dissipation member includes a producing step using the laminate described above. The producing method can produce a heat dissipation member by a known processing means.

[3. Heat Dissipation Housing]

In an embodiment, the heat dissipation housing according to this invention has the laminate described above. The heat dissipation housing may further include a housing body capable of housing an electronic device such as an inverter and an ECU. For example, the housing body may be made of a resin, with its inner surface being the laminate. In this case, the heat dissipating housing can be insert-molded using the laminate as an insert part. With these configurations, heat generated by the electronic device housed in the heat dissipation housing can be transferred to the laminate and dissipated to the outside via the laminate. As a result, the increase in the temperature of the electronic device is suppressed and does not cause the electronic device to malfunction.

Furthermore, the heat dissipating housing may have the housing body that is the laminate.

The heat dissipation housing according to this invention can also be used for electromagnetic shielding applications.

In an embodiment, the method for producing the heat dissipation housing includes a producing step using the laminate described above. The producing method can produce a heat dissipation housing by a known processing means.

[Examples]

Hereinafter, embodiments of the present invention will be specifically described based on Examples, Comparative Examples and Reference Examples. The following Examples, Comparative Examples, and Reference Examples are merely illustrative examples intended to facilitate understanding of the technical content of this invention, and the technical scope of this invention is not limited to these illustrative examples.

[Preparation of Laminate]

In Examples 1 to 5, metal layers 1 to 2 and a resin layer 1 were prepared as materials according to the order of the layers shown in Table 1. For the metal layer 2, an annealing process was performed under conditions of a material temperature of 200°C and a heating holding time of 1 hour, and for the metal layer 1, an annealing process was performed under conditions of a material temperature of 200°C and a heating holding time of 1 hour after each processed film was provided, as described below.

The metal layers 1 to 3 in Table 1 are as follows. As the resin layer 1, a commercially available resin film (nominal thickness: 100 $\mu$m) was used.

Metal layer 1: copper foil (nominal thickness of 18 $\mu$m, tough pitch copper (JIS H 3100 (C1100): 2018 standard), manufactured by X Advanced Metals Corporation);
Metal layer 2: aluminum foil (nominal thickness of 35 $\mu$m, A1050 (JIS H 4000: 2017 standard), commercially available product);
Metal layer 3: SUS 304 steel sheet (nominal thickness of 300 $\mu$m, TS300-300-03, manufactured by IWATA MFG CO., LTD.).

Next, in Examples 1 to 4, the following films were formed as a processed film on the surface of the metal layer 1 facing the resin layer in the following order: (A) an auxiliary electromagnetic wave absorbing film, (B) a heat resistant film, (C) a heat resistant film, (D) a rust proofing film, and (E) a weather resistant film. The above processed film was formed to bond the resin layer 1 to the surface of the metal layer 1. The formation time was adjusted appropriately so that the thickness of the processed film was about submicron ($10^{-1}$ $\mu$m or less). Of the surfaces of the metal layer 1, the side that was in contact with air (the top surface side) was processed with (C) the heat resistant film and (D) the rust proofing film. The annealing process was performed under conditions of a material temperature of 200°C and a heating holding time of 1 hour after each processed film was provided, as described below.

(A) Auxiliary Electromagnetic Wave Absorbing Film (Cu-Co-Ni Alloy Plating (Roughened Plating))

Liquid composition: 15.5 g/L of copper, 7.0 g/L of cobalt, 9.3 g/L of nickel;
pH: 2.3;
Liquid temperature : 36.0°C;
Current density :

(Upper surface) first time: 21.3 A/dm$^2$, second time: 29.9 A/dm$^2$, third time: 56.8 A/dm$^2$;
(Lower surface) first time: 14.9A/dm$^2$, second time: 26.1A/dm$^2$, third time: 56.8A/dm$^2$;
Coulomb amount:

(Upper surface) first time: 15.3 As/dm$^2$, second time: 21.5 As/dm$^2$, third time: 20.5 As/dm$^2$;
(Lower surface) first time: 10.7 As/dm$^2$, second time: 18.8 As/dm$^2$, third time: 27.4 As/dm$^2$;

(B) Heat Resistant Film (Co-Ni Alloy Plating)

Liquid composition: 12.5 g/L of nickel, 3.1 g/L of cobalt;
pH: 2.0;
Liquid temperature: 50°C;
Current density: (upper surface) 17.5A/dm$^2$, (lower surface) 19.3A/dm$^2$;
Coulomb amount: (upper surface) 6.3 As/dm$^2$, (lower surface) 6.9 As/dm$^2$;

(C) Heat Resistant Film (Ni-Zn Alloy Plating)

Liquid composition: 23.5 g/L of nickel, 4.5 g/L of zinc;
pH: 3.7;
Liquid temperature: 40°C;
Current density: (upper surface) 3.6 A/dm$^2$, (lower surface) 4.0 A/dm$^2$;
Coulomb amount: (upper surface) 1.5 As/dm$^2$, (lower surface) 1.6 As/dm$^2$;

(D) Rust Proofing Film (Immersion Chromate Process)

Liquid composition: 3.0 g/L of potassium dichromate, 0.33 g/L of zinc;
pH: 3.65;
Liquid temperature: 55°C;
Processing time: 5 seconds;

(E) Weather Resistant Film (Silane Coupling Process)

Silane coupling agent: N-(2-aminoethyl)-3-aminopropyltrimethoxysilane;
Silane coupling agent concentration: 1.2 vol%;
Processing temperature: 20°C (room temperature); and
Processing time: 5 seconds.

Next, in Examples 1 to 5, to produce a laminate by laminating a metal layer and a resin layer, an adhesive layer was formed between the metal layer and the resin layer via an adhesive (RU80/H-5 (urethane adhesive for dry lamination, manufactured by ROCK PAINT Co., Ltd.)). The thickness of each of these adhesive layers was about 5 μm.

This produced sheet-shaped laminates in Examples 1 to 5. In Comparative Example 1, a SUS 304 steel sheet was used. Also, as Reference Example 1, the sheet of the resin layer 1 were used.

[Characterization]

(Unit Weight)

According to the method described above, the unit weights of Examples 1 to 5, Comparative Example 1 and Reference Example 1 were measured. Table 1 shows the results.

(Thermal Diffusivity)

The thermal diffusivities of Examples 1 to 5, Comparative Example 1, and Reference Example 1 were measured using a thermophysical property measuring device, Thermowave Analyzer TA35 Ultimate, according to the method described above. Except for Example 3, the thermal diffusivity in the direction perpendicular to the lamination direction of the laminate (which means the thickness direction in Comparative Example 1 and Reference Example 1) was measured at five points near the center of the surface of each sample, and the arithmetic average value thereof was listed in Table 1. For Example 3, the thermal diffusivity of the laminate in the direction perpendicular to the lamination direction was measured at one point near the center of the surface of the sample. The results are shown in Table 1.

(Evaluation of Heat Dissipation Properties of Sheet-shaped Sample)

The heat dissipation properties of Examples 1 to 5, Comparative Example 1, and Reference Example 1 were evaluated according to the following procedures (1) to (5):

(1) Examples 1 to 5, Comparative Example 1 and Reference Example 1 were cut with scissors to obtain samples each having 5 cm x 5 cm. The surface of each sample was coated with a blackbody spray (TA410KS, manufactured by TASCO; emissivity of 0.94) to ensure a constant emissivity.

(2) In the heat dissipation evaluation device 100 shown in FIG. 1, a sheet-shaped sample 110, a heat dissipation resin (a thickness of 1000 $\mu$m; TMS-E14N, manufactured by TAKEUCHI INDUSTRY CO., LTD.) 120, a heating unit 130, and a low dielectric resin (a thickness of 400 $\mu$m; GHPL-830NX type A, manufactured by MITSUBISHI GAS CHEMICAL COMPANY, INC.) 140 were arranged in this order from the top. At this time, a heater (WALN-5, manufactured by SAKAGUCHI ELECTRIC HEATERS CO., LTD.) 132 and a thermocouple 134 were connected to the heating unit 130. The current to the heater 132 was supplied from a constant voltage power source (model PMX18-2A, manufactured by KIKUSUI), and signal control to the power source was performed using Wavy for PMX Free software, and current application and stopping were performed by creating a sequence on the software. The temperature measurements from the thermocouple 134 were constantly recorded in a data logger (model LR8431, manufactured by HIOKI) during the test. A thermal camera 150 (model C51.1, manufactured by FLIR) was installed at a position of 30 cm above the sheet-shaped sample 110.

(3) A heat dissipation resin 120 of the same area was placed on the heating unit 130, and Examples 1 to 5, Comparative Example 1 and Reference Example 1 were attached to it, and then a fixed voltage of 10 V was applied to the heater 132 for 20 seconds. After 20 seconds, the application was stopped.

(4) After 2 minutes of the start of application of the voltage, the temperature of the sheet-shaped sample 110 was immediately measured using a thermo-camera 150 disposed above the sheet-shaped sample 110. Table 1 shows the maximum temperature of the sheet-shaped sample 110. When the maximum temperature of the heating unit 130 was rapidly measured with the thermocouple 134 immediately after the application of the voltage was stopped with no sample placed thereon, it was 65°C.

(Evaluation of Heat Dissipation Properties of Three-Dimensional Molded Sample)

The heat dissipation properties of Examples 1 to 5, Comparative Example 1, and Reference Example 1 were evaluated according to the following procedures (1) to (8): In the following procedures (2) to (4), samples were produced by a drawing process at room temperature (about 22 to 26°C).

(1) Examples 1 to 5, Comparative Example 1 and Reference Example 1 were cut with scissors to obtain polygonal samples 210 as shown in FIG. 2. At this time, a length L of a diagonal line between an apex A of the polygonal sample 210 and an apex B opposite to the apex A was set to 72 mm.

(2) The outer periphery of the polygonal sample 210 was clamped between a die 220 and a holder 230 of the processing machine 200 shown in FIG. 3(A).

(3) As shown in FIG. 3(B), a punch 240 (a size of a tip surface: 30 mm $\times$ 40 mm) was vertically moved downward by 15 mm along the die 220 and the holder 230 and pushed into the die hole. The clearance between the die 220 and the punch 240 was set to 0.6 mm.

(4) As shown in FIG. 3(C), the punch 240 was vertically moved upward and returned to its original position. As a result, a drawn three-dimensional molded sample 215 was obtained. The three-dimensional molded sample 215 had a bottomed shape. In addition, since in Comparative Example 1, the bottom portion was damaged by the drawing process, it was bent and processed so that the tip surface had a size of 30 mm x 40 mm and a height of 15 mm. The convex outer surface of each sample was coated with a blackbody spray (TA410KS, manufactured by TASCO; emissivity of 0.94) to ensure a constant emissivity.

(5) In the heat dissipation evaluation device 300 shown in FIG. 4, to clamp the outer periphery of the three-dimensional molded sample 215, a heat dissipation resin (a thickness of 1000 $\mu$m, TMS-E14N, manufactured by TAKEUCHI INDUSTRY CO., LTD.) 320, the outer periphery of the three-dimensional molded sample 215, copper foil (a thickness

of 18 $\mu$m, TPC, manufactured by JX Advanced Metals Corporation) 360, a low dielectric resin (a thickness of 400 $\mu$m, GHPL-830NX type A, manufactured by MITSUBISHI GAS CHEMICAL COMPANY, INC.) 340, and copper foil (a thickness of 18 $\mu$m, TPC, manufactured by JX Advanced Metals Corporation) 365 were arranged in this order from the top. The heating unit 330 was placed on the low dielectric resin 340 so that the center of gravity of the three-dimensional molded sample 215 and the center of gravity of the heating unit 330 overlapped with each other when viewed from above. At this time, a heater 332 and a thermocouple 334 were connected to the heating unit 330. The current to the heater was supplied from a constant voltage power source (model PMX18-2A, manufactured by KIKUSUI), and signal control to the power source was performed using Wavy for PMX Free software, and current application and stopping were performed by creating a sequence on the software. The temperature measurements from the thermocouple 334 were constantly recorded in a data logger (model LR8431, manufactured by HIOKI) during the test. A thermal camera 350 (model C51.1, manufactured by FLIR) was installed at a position of 30 cm above the three-dimensional molded sample 215.

(6) A voltage fixed at 10 V was applied to the heater 332 for 70 seconds. After 70 seconds, the application was stopped.

(7) After the application of the voltage was stopped, the temperature of the heating unit 330 was immediately measured by the thermocouple 334. As a result, in Examples 1 to 5, Comparative Example 1 and Reference Example 1, the temperature was 370°C.

(8) Furthermore, after 2 minutes of the start of application, the temperature of the three-dimensional molded sample 215 was rapidly measured with a thermo camera 350 placed above the three-dimensional molded sample 215. Table 1 shows the maximum temperature of the three-dimensional molded sample 215.

(Determination for Heat Dissipation)

In the heat dissipation evaluation of the sheet-shaped sample and the three-dimensional molded sample, each sample was measured after two minutes of the start of the application of the voltage. The results are shown in Table 1: when the maximum temperatures of both samples were 40°C or lower, it was represented by "double circle", when it was higher than 40°C and lower than 45°C, it was represented by "circle", and when it was other than those, it was represented by "triangle". In addition, the heat dissipation was determined to be good when it was represented by "double circle" or "circle", while the heat dissipation was determined to be not good when it was represented by "triangle".

(Shielding Properties)

Shielding properties in the sheet shape were measured for Examples 1 to 5, Comparative Example 1, and Reference Example 1, respectively. First, the outer periphery of each sample was fixed with a tape to prevent displacement during measurement. The magnetic field shielding properties were evaluated at room temperature (about 22 to 26°C) using the KEC method at a frequency of 100 kHz with a magnetic field measuring jig of a KEC method shielding effect measuring device (Techno Science, JSE-KEC), a network analyzer (Keysight Technologies, E5080), and an amplifier (Anritsu, MH648A). The results are shown in Table 1.

[Table 1]

| | Laminate Structure | Evaluation Results | | | | | |
|---|---|---|---|---|---|---|---|
| | | | | Heat Dissipation Test | | | KEC Method Shield Effect Measureme |
| | Materials | Unit Weight [kg/m$^2$] | Thermal Diffusivity [m$^2$/s] | Sheet-shaped | Three-Dimensional Molded Sample | Determination Results | Value at 100 kHz [dB] |
| | | | | Temperature after 2 min of Start of Application [°C] | Temperature after 2 min of Start of Application [°C] | | |
| Example 1 | Metal Layer 1/Resin Layer 1 | 0.29 | 51.3 × 10$^{-6}$ | 32.4 | 35.0 | | 10 |
| Example 2 | Resin Layer 1/Metal Layer 1/Resin Layer 1 | 0.44 | 18.1 × 10$^{-6}$ | 32.1 | 39.2 | | 10 |
| Example 3 | Metal Layer 1/Resin Layer 1/Metal Layer 1/Resin Layer 1 | 0.6 | 96.1 × 10$^{-6}$ | 31.3 | 34.5 | | 15 |
| Example 4 | Metal Layer 1/Resin layer 1/Metal Layer 1/Resin Layer 1/Metal Layer 1/Resin Layer 1 | 0.92 | 114 × 10$^{-6}$ | 31.4 | 38.5 | | 16 |
| Example 5 | Resin Layer 1/Metal Layer 2/Resin Layer 1 | 0.91 | 23 × 10$^{-6}$ | 33.8 | 39.1 | | 10 |
| Comparative Example 1 | Metal Layer 3 | 2.38 | 4.16 × 10$^{-6}$ | 35.4 | 50.1 | Δ | 7 |

(continued)

| | Laminate Structure | Evaluation Results | | | | | |
|---|---|---|---|---|---|---|---|
| | | | | Heat Dissipation Test | | | KEC Method Shield Effect Measureme |
| | Materials | Unit Weight [kg/m²] | Thermal Diffusivity [m²/s] | Sheet-shaped | Three-Dimensional Molded Sample | Determination Results | Value at 100 kHz [dB] |
| | | | | Temperature after 2 min of Start of Application [°C] | Temperature after 2 min of Start of Application [°C] | | |
| Reference Example 1 | Resin Layer 1 | 0.14 | $0.65 \times 10^{-6}$ | 34.5 | 62.0 | Δ | < 1 |

(Consideration by Examples)

The laminates according to Examples 1 to 5 were those having at least one metal layer and at least one resin layer, and the unit weight of each laminate was 2.0 kg/m² or less, and the thermal diffusivity of each laminate in the direction perpendicular to the lamination direction was $10 \times 10^{-6}$ m²/s or more, thereby achieving weight reduction and good heat dissipation properties. Furthermore, the laminates according to Examples 1 to 5 had a shielding effect of 10 dB or more at 100 kHz, and the shielding properties were also good.

According to Table 1 described above, the heat dissipation properties of Example 4 were slightly inferior to those of Example 3, which had a slightly inferior thermal diffusivity. As its reasons, it is presumed that the heat dissipation properties become saturated when the thermal diffusivity reaches or exceeds the certain value.

On the other hand, since Comparative Example 1 was composed of only a metal layer, the unit weight was higher than that of each laminate according to Examples 1 to 5 by 2.4 times or more.

[Description of Reference Numerals]

100, 300 heat dissipation evaluation device
110 sheet-shaped sample
120, 320 heat dissipation resin
130, 330 heat unit
132, 332 heater
134, 334 thermocouple
140, 340 low dielectric resin
150, 350 thermo camera
200 processing machine
210 polygonal sample
215 three-dimensional molded sample
220 die
230 holder
240 punch
360, 365 copper foil
A, B Apex
L length of diagonal

**Claims**

1. A laminate having at least one metal layer and at least one resin layer, wherein a unit weight of the laminate is 2.0 kg/m$^2$ or less, and a thermal diffusivity of the laminate in a direction perpendicular to a lamination direction is $10 \times 10^{-6}$ m$^2$/s or more.

2. The laminate according to claim 1, wherein the thermal diffusivity of the resin layer in the direction perpendicular to the lamination direction is $0.05 \times 10^{-6}$ to $0.70 \times 10^{-6}$ m$^2$/s.

3. The laminate according to claim 1 or 2, wherein the resin layer comprises a magnetic metal material.

4. The laminate according to any one of claims 1 to 3, wherein the metal layer comprises at least one selected from copper, copper alloy, aluminum, and aluminum alloy.

5. A heat dissipation member having the laminate according to any one of claims 1 to 4.

6. A method for manufacturing a heat dissipation member, the method comprising a step of manufacturing a heat dissipation member using the laminate according to any one of claims 1 to 4.

7. A heat dissipation housing having the laminate according to any one of claims 1 to 4.

8. A method for manufacturing a heat dissipation housing, the method comprising a step of manufacturing a heat dissipation housing using the laminate according to any one of claims 1 to 4.

[FIG. 1]

[FIG. 2]

210

A          B

L

[FIG. 3]

[FIG. 4]

## INTERNATIONAL SEARCH REPORT

| | International application No. |
|---|---|
| | **PCT/JP2024/021565** |

**A.    CLASSIFICATION OF SUBJECT MATTER**

*H05K 7/20*(2006.01)i; *B32B 15/08*(2006.01)i; *H01L 23/36*(2006.01)i; *H05K 9/00*(2006.01)i
FI:    H05K7/20 B; H05K9/00 M; B32B15/08 D; H01L23/36 D; H05K9/00 W

According to International Patent Classification (IPC) or to both national classification and IPC

**B.    FIELDS SEARCHED**

Minimum documentation searched (classification system followed by classification symbols)

H05K7/20; B32B15/08; H01L23/36; H05K9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | JP 2016-100561 A (DAI NIPPON PRINTING CO., LTD.) 30 May 2016 (2016-05-30) paragraphs [0045]-[0054], fig. 5 | 1-8 |
| Y | JP 2015-065450 A (MITSUI CHEMICALS, INC.) 09 April 2015 (2015-04-09) paragraph [0028] | 1-8 |
| Y | JP 2022-084611 A (MAXELL LTD.) 07 June 2022 (2022-06-07) paragraphs [0028]-[0040], fig. 1 | 3 |

☐ Further documents are listed in the continuation of Box C.     ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **05 August 2024** | **13 August 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

### INTERNATIONAL SEARCH REPORT
Information on patent family members

| International application No. |
| --- |
| **PCT/JP2024/021565** |

| Patent document cited in search report | | | Publication date (day/month/year) | Patent family member(s) | | | Publication date (day/month/year) |
| --- | --- | --- | --- | --- | --- | --- | --- |
| JP | 2016-100561 | A | 30 May 2016 | (Family: none) | | | |
| JP | 2015-065450 | A | 09 April 2015 | US | 2013/0045347 | A1 | |
| | | | | paragraph [0037] | | | |
| | | | | WO | 2011/135860 | A1 | |
| | | | | KR | 10-2013-0019402 | A | |
| JP | 2022-084611 | A | 07 June 2022 | US | 2019/0269048 | A1 | |
| | | | | paragraphs [0041]-[0053], fig. 1 | | | |
| | | | | WO | 2018/016522 | A1 | |
| | | | | EP | 3490358 | A1 | |
| | | | | CN | 109479388 | A | |

Form PCT/ISA/210 (patent family annex) (July 2022)

22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2020172694 A

**Non-patent literature cited in the description**

• **KIYOSHI MARUYAMA**. Plating Practice Reader. The Nikkan Kogyo Shimbun, 30 June 1983, 157-160